# EUROPEAN PATENT APPLICATION

(11) **EP 4 560 311 A2**
(43) Date of publication of application: **28.05.2025**
(21) Application number: 24306921.8
(22) Date of filing: 18.11.2024
(51) Int. Cl.: G01N 27/92

(54) **AUTOMATED ELECTRICAL CHARACTERIZATION ON HV CABLE PEELING**

(30) Priority: 27.11.2023 NO 20231290
(71) Applicant: Nexans, 92400 Courbevoie (FR)
(72) Inventor: DOEDENS, Espen, 92400 COURBEVOIE (FR)
(74) Representative: Onsagers AS

(57) **Abstract**

The present invention relates to an analysis device (1) for measuring electrical properties of an insulating material which analysis device (1) comprises a sample releasing unit (14), a sample receiving unit (15), an electrical drive unit for moving a sample from the sample releasing unit (14) to the sample receiving unit (15), a first electrode (11) and a second electrode (12), a voltage source (10) electrically connected to the first electrode (11), and a control unit (16). The present invention further relates to a method of analyzing electrical properties of an insulating material. The present invention also relates to a method of analyzing the surface potential decay (SPD) of an insulating material.

## Description

### FIELD OF THE INVENTION

The present invention relates to an analysis device for measuring electrical properties of an insulating material which analysis device comprises a sample releasing unit, a sample receiving unit, an electrical drive unit for moving a sample from the sample releasing unit to the sample receiving unit, a first electrode and a second electrode, a voltage source electrically connected to the first electrode, and a control unit. The present invention further relates to a method of analyzing electrical properties of an insulating material. The present invention also relates to a method of analyzing the surface potential decay (SPD) of an insulating material.

### BACKGROUND

High-voltage electric power transmission systems have become of increased significance in the energy transition as these systems enable long distance energy connections which could help to deal with the fluctuations of wind power and photovoltaics.

High voltage cables typically comprise a central electrical conductor, mostly aluminum or copper, and successively and coaxially around this electrical conductor, a semiconductive inner layer, an electrically insulating intermediate layer, a semiconducting outer layer. These layers are based on polymer(s), which can be crosslinked or not.

A key factor for high voltage cables concerns the insulating material surrounding the metal conductor in the center of the cable. Considerable research and development efforts have been spent to improve the insulating material. In the course of these efforts, it requires to analyze samples of the insulating material. The aim is to investigate cable health which may vary with the radial, longitudinal and angular location in the cable insulation. For example, electrical measurements on the full cable sample require long segments of cable and are thus costly and may not resolve the spatial variations. The preparation of samples of distinguishing spatial positions within the insulating material of the cable is time consuming and elaborate.

In one approach a re-melting of segments of cable insulation into plates have been performed. However, firstly the method can only be performed with non-XLPE insulating materials as the cross-linked insulating materials cannot be remelted, secondly the melting affects morphological insulation properties. Typically, such methods are performed with virgin pellet materials. However, the method allows no approach in investigating cable health. Cutting peelings and thin parts from the full samples is thus preferred, as it only requires short cable segments and provides spatial resolution. The main alternatives to peelings are e.g. slicing or CNC milling which however results in much thicker specimens. Samples can further be obtained by microtomy, where one receives very small samples, which are not distributed around the cable.

One of the key properties of high voltage cables concerns the breakdown voltage. Its measurement is elaborate and challenging in terms of reliability. Single measurements typically result in large standard deviations as the insulating material may have a distinct breakdown voltage in a slightly different spatial position next to the position of measurement and a repetition of one measurement, if it was practically possible, may also result to a different breakdown voltage. Therefore, a series of measurements is required to fully characterize the electrical stability of an insulting material of a high voltage cable.

A problem solved by the invention relates to the provision of a device and a method which enable a comprehensive characterization of the electrical stability and electrical properties of insulating materials for high voltage cables.

### SUMMARY OF THE INVENTION

The invention's underlying problems are solved by the subject-matter of claim 1. A first aspect of the invention therefore relates to an analysis device for measuring electrical properties of an insulating material which analysis device comprises a sample releasing unit, a sample receiving unit, an electrical drive unit for moving a sample from the sample releasing unit to the sample receiving unit, a first electrode and a second electrode, wherein the first electrode and the second electrode are arranged opposing one another, and wherein the first electrode and the second electrode are arranged between the sample releasing unit and sample receiving unit, a voltage source electrically connected to the first electrode, and a control unit, wherein the control unit is configured to control the electrical drive unit and the voltage source.

The analysis device enables a comprehensive study of the electrical strength of the insulating material of high voltage cables. The challenge of a comprehensive study lays in the property of breakdown measurements being associated with a considerable statistical error. One of the key factors which enables solving the invention's underlaying problem relates to the control unit which is configured to control the electrical drive unit and the voltage source.

The sample releasing unit and the sample receiving unit together with the drive unit allow to spool the sample material through the probe unit, i.e. the unit in which the actual sample is under physical treatment and measurement. Both units may comprise reflection rollers or guide roller guiding the sample, i.e. such roller are integral part of the sample releasing unit and sample reflection unit.

The analysis device further comprises a first electrode and a second electrode. The first electrode serves as the high voltage electrode connected to the voltage source. The second electrode receives the current when the breakdown event takes place.

According to the invention, the first electrode and the second electrode are arranged between the sample releasing unit and sample receiving unit. This feature is to be understood in the framework of its function. For the actual measurement of the electrical stability or the electrical property, the sample of the cable is to be guided through the gap between the first electrode and the second electrode. For that purpose, the sample is guided from one side of the electrodes and leaving the gap between the electrodes on the other side. The roller releasing the sample and the roller receiving the sample may be arranged anywhere else than aside the electrodes. Rollers belonging to the sample releasing unit and the sample receiving unit guide the sample such that the sample is passed through the gap of the electrodes.

Therefore, the feature according to which the first electrode and the second electrode are arranged between the sample releasing unit and the sample receiving unit means that the sample releasing unit and the sample receiving unit are arranged such that the guidance of the sample through the gap between the first electrode and the second electrode is enabled.

The term "sample" is understood throughout this application as a part of the cable to be analyzed. The sample is preferably a part of an extruded HVDC cable or an HVAC cable. The sample is more preferred a part of the insulating layer of an extruded HVDC cable. The sample is a part of the cable to be analyzed, preferably a peeling sample of an electric cable, more preferred a peeling sample of an extruded HVDC cable. Most preferred, the sample is a peeling sample.

In one aspect, the analysis device further comprises detection means configured to detect a marking on the sample. And in one aspect, the control unit is configured to correlate the marking on the sample to a spatial portion of the insulating material. The markings allow to link the position on the sample to the spatial position in the cable. In practice, the cable to be analyzed is provided with a marking like e.g. a slit. The cable is subjected to a peeling step to obtain a peeling sample on which the marking is perceptible, e.g. the slit is repeatedly seen on the peeling sample such that the position on the peeling sample can be linked to the spatial position in the cable being subjected to the peeling step. By using detection means, the device enables to issue a virtual cable with information on the electrical strength at all spatial positions in the cable.

In one aspect, the minimum distance between the first electrode and the second electrode is such that the first electrode and the second electrode can both be brought in contact with the sample. The distance between the first electrode and the second electrode is preferably such that the electrodes contact the sample from both sides, i.e. from the side of the first electrode and the side of the second electrode. Therefore, the minimum distance between the first electrode and the second electrode corresponds to the thickness of the sample.

In one aspect, the first electrode comprises a tip being a metal ball rotatably arranged to the first electrode. The preferred analysis device enables an easy movement of the sample through the gap between the first electrode and the second electrode.

In one aspect, the second electrode is connected to ground potential. The analysis device is enabled to perform a breakdown instance. The control unit needs to record the voltage at which the breakdown actually occurred.

In one aspect, the analysis device further comprises a device for measuring the thickness of the sample. Information on the thickness enable the calculation of the breakdown voltage per length of the sample.

In one aspect, the analysis device further comprises an electrical charging device, preferably a corona gun. In order to perform a surface potential decay (SPD) measurement, it requires that the analysis device comprises possibilities to charge the surface of the sample.

In one aspect, the analysis device is configured to perform AC breakdown measurements, DC breakdown measurements and/or surface decay measurements. The main electrical properties to be measured are breakdown voltages for both direct current (DC) and alternating current (AC).

The invention's underlying problems are further solved by the subject-matter of claim 10. A second aspect of the invention therefore relates to a method of analyzing electrical properties of an insulating material, wherein the method comprises the steps of a) providing a sample of the insulating material, b) introducing the sample into a sample releasing unit, attaching an end portion of the sample to a sample receiving unit, and arranging a portion of the sample between the first electrode and the second electrode, c) applying a voltage to the first electrode, wherein the voltage increases over time, d) detecting the voltage at which breakdown occurs in the area of the sample between the first electrode and the second electrode, e) moving the sample by the drive unit, wherein the control unit controls steps c) and e).

The method comprises the automatic guidance of the sample of the insulating material through two opposing electrodes. The drive unit moves the sample controlled by the control unit. The control unit also controls the application of a voltage to the first electrode. The voltage is increased over time. In the course of increasing the voltage, a moment will be reached in which the material cannot stand the voltage such that a sudden discharge occurs.

The voltage at which this discharge occurs is stored on a storing medium as breakdown voltage. The essential feature of the method according to the invention is the control of method step c) depending on method step e). Further method step may be controlled by the control unit additionally. For example, the control unit may comprise a storage unit for storing the measured data.

In step b), the sample, preferably the peeling sample, is introduced into the analysis device. The order of actions for the arrangement is arbitrary, i.e. the sample can be arranged between the electrodes first, then the end portion can be attached to the receiving unit.

The step e) of moving the sample by the drive unit means that the sample is spooled from the releasing unit to the receiving unit. Preferably, the method is stopped by the control unit as the sample is moved from the releasing unit all down to the receiving unit.

The skilled person understands that the order of performing steps c) and e) are arbitrary. The sample can be introduced between the electrodes first and then the first breakdown measurement is made or the sample can firstly be moved to the first spot of measurement and then the first breakdown measurement is performed.

In one aspect, the method of analyzing electrical properties of an insulating material is performed by using the analysis device according to the first aspect of the invention.

In one aspect, step e) is not performed concurrently with step c) and step c) is not performed concurrently with step e).

This preferred method represents a stop-and-go alternative of performing the method. The control unit performs steps c) until the breakdown incident occurs, the breakdown voltage is stored on a storing unit. During that step, the sample is not moved forward, i.e. the drive unit does not spool the sample forward.

In one aspect, steps c) to e) are reiterated. By reiterating steps c) to e) the sample is analyzed throughout its length. If the sample is a peeling sample, the reiteration enables a mapping of the cable material in view of its electrical properties, in particular its electrical strength properties.

In one aspect, step c) is performed by applying a voltage pattern, preferably by applying a linear voltage pattern comprising a linear increase of voltage over time.

The term "voltage pattern" is understood such that the voltage follows a predefined function of voltage versus time. In the linear voltage pattern, the voltage applied to the first electrode is linearly increased over time. Such pattern makes the measurement of the voltage breakdown most reproducible. The "linear voltage pattern" may comprise a stepwise linear increase of voltage over time.

In one aspect, the method of analyzing electrical properties comprises measuring AC breakdown or measuring DC breakdown.

Both measurements characterize the materials of a cable. The method according to the invention enables the measurement of both AC breakdown and DC breakdown.

In one aspect, the method of analyzing electrical properties comprises measuring DC breakdown, wherein step e) is not performed concurrently with step c) and step c) is not performed concurrently with step e).

It is most preferred that DC breakdown is measured. Its most preferred way of measuring is performed in a stop-and-go process. When the voltage is increased in performing step c), the movement of the sample is interrupted, i.e. step e) is not performed. After the breakdown incident has occurred and the voltage at breakdown is measure, the sample moves forward by the drive unit initiated and controlled by the control unit.

In one aspect, the method of analyzing electrical properties comprises measuring AC breakdown, wherein step e) is at least temporarily performed concurrently with step c).

While the DC breakdown measurement is preferably performed in the stop-and-go process, AC breakdown measurements are preferably performed while the sample moves forward. This method saves time and is thus more efficient.

In one aspect, prior to step a), the insulating material is provided with at least one marking being detectable on the sample, wherein the method comprises steps f) detecting the at least one marking and thereby providing information on the lengthwise position of the at least one marking on the sample, and g) by using the control unit and based on the information on the lengthwise position, calculating the spatial position of the area of measurement of the electrical property in the insulating material.

The preferred method enables a mapping of the electrical property to the spatial position of the property in the cable material. The making can be produced by drilling a hole in the direction of the center of the electric cable. When performing the peeling of the cable, the marking is visible on the obtained peeling sample. When counting the markings in the lengthwise direction of the cable, one may link the position of the peeling sample to the spatial position in the cable.

In one aspect, the method comprises a step h) of measuring the thickness of the sample.

The information of the thickness allows the determination of the electrical property per unit length of the sample material. The measurement of the thickness is preferably performed such that the thickness is obtained at the area of measurement of the electrical property.

In one aspect, the control unit stops the method when the drive unit has moved essentially the whole sample from the sample releasing unit to the sample receiving unit.

The invention's underlying problems are further solved by the subject-matter of claim 20. A third aspect of the invention therefore relates to a method of analyzing the surface potential decay of an insulating material, wherein the method comprises the steps of a) providing a sample of the insulating material, b) introducing the sample into a sample releasing unit and attaching an end portion of the sample to a sample receiving unit having a portion of the sample arranged between the first electrode and the second electrode, c) loading charge on the peeling sample by use of an electrical charging device, preferably a corona gun or a contact charge roller, d) measuring the potential decay over time, e) moving the sample by the drive unit, wherein the control unit controls steps c) and e).

The method of the invention enables the measurement of the surface potential decay (SPD) as an electrical property which characterizes the cable material. By use of e.g. a corona gun or a contact charge roller, a charge is deposited on the surface. Single or multiple electrostatic probes (like e.g. a Kelvin probe or a vibrating probe) are used to measure the surface potential after a certain time has elapsed.

The corona charging comprises needles or sharp wires spaced 1-20mm from the surface that deposit surface charges. The voltage probe is located 1-20 mm from the surface and measures a voltage generated by the deposited surface charges.

The method of measuring SPD can be performed in a continuous manner, i.e. steps c) to e) are performed at least partially at the same time, or the method of measuring SPD can be performed in a stop-and-go manner, i.e. steps c) and d) are performed while step e) is not performed and step e) is performed while steps c) and d) are not performed.

In one aspect, the step of providing a sample of the insulating material comprises the step of subjecting the insulating material to a peeling to receive a peeling sample.

Features being solely disclosed in connection with the analysis device of the invention are deemed to be disclosed in connection with the methods of the invention and vice versa.

### BRIEF DESCRIPTION OF THE DRAWINGS

Certain aspects of the presently disclosed subject-matter will be described with reference to the accompanying drawings, which are representative and schematic in nature and are not be considered to be limiting in any respect as it relates to the scope of the subject-matter disclosed herein:
Figure 1 depicts an analysis device according to the invention for measuring voltage breakdown; and
Figure 2 depicts the principle for measuring the surface potential decay.

### DESCRIPTION OF EMBODIMENTS

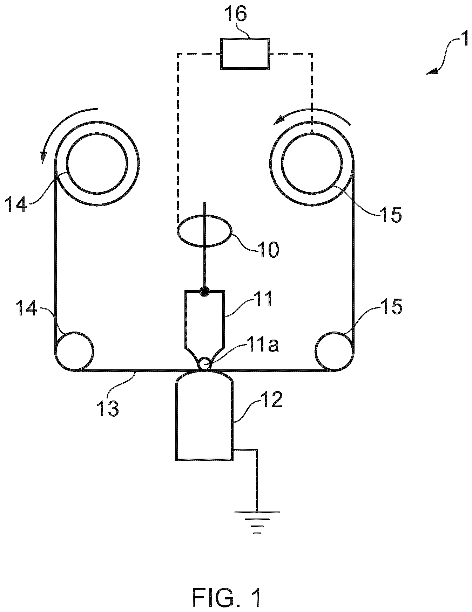

Fig. 1 shows an analysis device 1 according to the invention which enables measurement of the voltage breakdown. A sample 13 is moved from a sample releasing unit 14 through the gap between a first electrode 11 and a second electrode 12 to a sample receiving unit 15. The movement is performed by a drive unit which can be an integral part of the sample receiving unit 15. The first electrode 11 represents the high voltage electrode electrically connected to a voltage source 10. The voltage source 10 and the drive unit (not explicitly shown in Fig. 1) is connected to a control unit 16, which controls the voltage source 10 and the drive unit. The sample releasing unit 14 and the sample receiving unit 15 are arranged between the electrodes 11, 12 in the meaning of the present invention. The arrangement between the electrodes is understood such that the arrangement enable guiding the sample through the gap between the first electrode 11 and the second electrode 12. The units as shown in Fig. 1 each comprise a drum and a roller. A ball 11a arrange in the tip of the first electrode 11 helps in guiding the sample 13 through the gap.

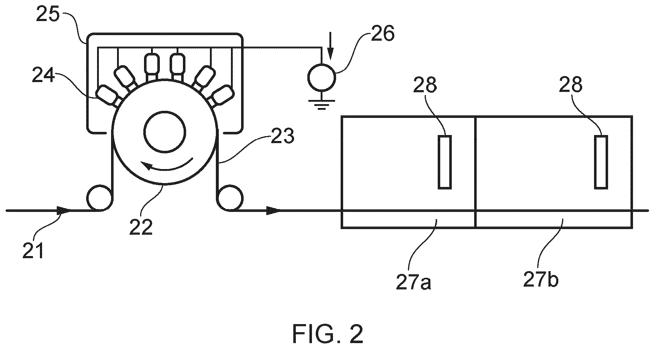

Fig. 2 shows a conventional device how to perform surface potential discharge measurements. A sample 21 is moved towards a roller 22 which is partially placed in a charging chamber 25. Before entering the charging chamber 25, the sample may be subjected to a corona discharging. In the charging chamber 25, electrodes 24 being connected with a voltage source 26 for supply of surface charge charge the sample surface, such that a charged sample 23 is obtained. In a first probe chamber 27a tempering to temperature T₁, a Kelvin electrostatic probe 28 measures the surface charge. In a second probe chamber 27b tempering to temperature T₂, a Kelvin electrostatic probe 28 measures the surface charge a second time after a certain time difference to the first surface charge measurement in the first probe chamber 27a. The device as shown in Fig. 2 can be provided with a sample releasing unit and a sample receiving unit, which are both not shown in Fig. 2.

### REFERENCE LIST

- 1: Analysis device
- 10: Voltage source
- 11: First electrode
- 11a: Ball in the first electrode
- 12: Second electrode
- 13: Sample
- 14: Sample releasing unit
- 15: Sample receiving unit
- 16: Control unit
- 21: Sample
- 22: Roller
- 23: Charged sample
- 24: Charging electrode
- 25: Charging chamber
- 26: Voltage source for supply of surface charge
- 27a: First probe chamber
- 27b: Second probe chamber
- 28: Kelvin electrostatic probes

## Claims

1. An analysis device (1) for measuring electrical properties of an insulating material which analysis device (1) comprises
a sample releasing unit (14);
a sample receiving unit (15);
an electrical drive unit for moving a sample (13) from the sample releasing unit (14) to the sample receiving unit (15);
a first electrode (11) and a second electrode (12), wherein the first electrode (11) and the second electrode (12) are arranged opposing one another, and wherein the first electrode (11) and the second electrode (12) are arranged between the sample releasing unit (14) and sample receiving unit (15);
a voltage source (10) electrically connected to the first electrode (11); and
a control unit (16), wherein the control unit (16) is configured to control the electrical drive unit and the voltage source (10).

2. The analysis device (1) according to claim 1, wherein the analysis device (1) further comprises detection means configured to detect a marking on the sample (13).

3. The analysis device (1) according to claim 2, wherein the control unit (16) is configured to correlate the marking on the sample (13) to a spatial portion of the insulating material.

4. The analysis device (1) according to any one of the preceding claims, wherein the minimum distance between the first electrode (11) and the second electrode (12) is such that the first electrode (11) and the second electrode (12) can both be brought in contact with the sample (13).

5. The analysis device (1) according to any one of the preceding claims, wherein the first electrode (11) comprises a tip being a metal ball (11a) rotatably arranged to the first electrode (11).

6. The analysis device (1) according to any one of the preceding claims, wherein the second electrode (12) is connected to ground potential.

7. The analysis device (1) according to any one of the preceding claims, wherein the analysis device (1) further comprises a device for measuring the thickness of the sample (13).

8. The analysis device (1) according to any one of the preceding claims, wherein the analysis device further comprises an electrical charging device, preferably a corona gun or a contact charge roller.

9. The analysis device (1) according to any one of the preceding claims, wherein the analysis device (1) is configured to perform AC breakdown measurements, DC breakdown measurements and/or surface decay measurements.

10. A method of analysing electrical properties of an insulating material, wherein the method comprises the steps of
a) providing a sample (13) of the insulating material;
b) introducing the sample (13) into a sample releasing unit (14), attaching an end portion of the sample (13) to a sample receiving unit (15), and arranging a portion of the sample (13) between the first electrode (11) and the second electrode (12);
c) applying a voltage to the first electrode (11), wherein the voltage increases over time;
d) detecting the voltage at which breakdown occurs in the area of the sample (13) between the first electrode (11) and the second electrode (12);
e) moving the sample (13) by the drive unit,
wherein the control unit (16) controls steps c) and e).

11. The method according to claim 9, wherein step e) is not performed concurrently with step c) and step c) is not performed concurrently with step e).

12. The method according to claim 9 or claim 10, wherein steps c) to e) are reiterated.

13. The method according to claim 9 to claim 11, wherein step c) is performed by applying a voltage pattern, preferably by applying a linear voltage pattern comprising a linear increase of voltage over time.

14. The method according to any one of claims 9 to 12, wherein the method of analysing electrical properties comprises measuring AC breakdown or measuring DC breakdown.

15. The method according to claim 13, wherein the method of analysing electrical properties comprises measuring DC breakdown, wherein step e) is not performed concurrently with step c) and step c) is not performed concurrently with step e).

16. The method according to claim 13, wherein the method of analysing electrical properties comprises measuring AC breakdown, wherein step e) is at least temporarily performed concurrently with step c).

17. The method according to any one of claims 9 to 15, wherein prior to step a), the insulating material is provided with at least one marking being detectable on the sample (13), wherein the method comprises steps
f) detecting the at least one marking and thereby providing information on the lengthwise position of the at least one marking on the sample (13), and
g) by using the control unit (16) and based on the information on the lengthwise position, calculating the spatial position of the area of measurement of the electrical property in the insulating material.

18. The method according to any one of claims 9 to 16, wherein the method comprises a step h) of measuring the thickness of the sample(13).

19. The method according to any one of claims 9 to 17, wherein the control unit (16) stops the method when the drive unit has moved essentially the whole sample (13) from the sample releasing unit (14) to the sample receiving unit (15).

20. A method of analysing the surface potential decay (SPD) of an insulating material, wherein the method comprises the steps of
a) providing a sample (13) of the insulating material;
b) introducing the sample (13) into a sample releasing unit (14) and attaching an end portion of the sample (13) to a sample receiving unit (15) having a portion of the sample (13) arranged between the first electrode (11) and the second electrode (12);
c) loading charge on the peeling sample (13) by use of an electrical charging device, preferably a corona gun, a needle electrode or a contact charge roller;
d) measuring the potential decay over time;
e) moving the sample (13) by the drive unit,
wherein the control unit (16) controls steps c) and e).

21. The method according to any one of claims 10 to 20, wherein the step of providing a sample (13) of the insulating material comprises the step of subjecting the insulating material to a peeling step to receive a peeling sample (13).
